# EUROPEAN PATENT SPECIFICATION

(11) **EP 1 241 703 B1**
(45) Date of publication and mention of the grant of the patent: **03.06.2009**
(21) Application number: 01600006.9
(22) Date of filing: 13.03.2001
(51) Int. Cl.: H01L 21/308, H01L 21/312

(54) **Method for masking silicon during anisotropic wet etching**
Verfahren zur Maskierung von Silizium für eine anisotrope Nassätzung
Procédé de masquage de silicium pour la gravure anisotrope par voie humide

(43) Date of publication of application: 18.09.2002
(73) Proprietor: National Center for Scientific Research Demokritos Institute of Microelectronics, 15310 Aghia Paraskevi, Attika (GR); Normand, Pascal, 15310 Aghia Paraskevi, Attika (GR); Tsoukalas, Dimitrios, 15310 Aghia Paraskevi, Attika (GR)
(72) Inventor: Normand, Pascal, 17237 Dafni Athens (GR); Beltsios, Konstantinos, 11523 Athens (GR); Tserepi, Angeliki, 15342 Aghia Paraskevi Attika (GR); Aidinis, Konstantinos, 16674 Glyfada Attika (GR); Tsoukalas, Dimitrios, 16675 Glyfada Attika (GR)

(56) References cited:
- DE-A- 19 844 418
- US-A- 4 371 407
- US-A- 5 079 178
- US-A- 5 116 460

## Description

The present invention relates to silicon micromachining technology. More particularly, this invention relates to a method for masking mono-crystalline or poly-crystalline silicon surfaces against wet chemical etchants during the fabrication of micromachined silicon structures.

Wet etching of single-crystal or poly-crystalline silicon is one of the most important techniques in silicon micromachining technology. Silicon wet etching allows for the fabrication of static and dynamic mechanical silicon structures such as nozzles, trenches, cavities, microprobes, diaphragms, membranes, microbridges, and cantilever beams (see, for example, "Sensor Technology and Devices", L. Ristic editor, ISBN 0-89006-532-2, Artech House (1994)). A wide variety of chemical reagents are used as etching solutions of silicon, the most common being potassium hydroxide (KOH), ethylenediamine-pyrocatechol-water (EPW), and tetramethylammonium hydroxide (TMAH). These chemical solutions induce a preferential etching of the crystal planes of silicon and are referred as anisotropic etchants. Anisotropic etchants are generally employed to form crystallographically-oriented silicon structures in a mono-crystalline silicon wafer. Such chemical solutions are also frequently used in surface micromaching to remove poly-crystalline silicon layers or in bulk micromachining to reduce the thickness of a silicon wafer. A silicon surface can be protected against anisotropic etchants by a wide variety of materials. Thermally grown and deposited silicon dioxide (SiO₂) films, as well as deposited silicon nitride (Si₃N₄) films are the most common masking materials against all three of the aforementioned anisotropic etchants. Metal films such as gold, chromium, silver and tantalum are also suitable etch masks to use with EPW solutions.

The fabrication of silicon structures in a silicon wafer through wet etching of silicon involves at least two preliminary steps, namely (1) formation of a masking material such as SiO₂, Si₃N₄, or metal films, onto the surface of the silicon wafer, and (2) patterning of the masking material. Patterning can be achieved by standard photolithographic procedures followed by suitable dry or wet etching processes leading to the removal of the masking material in the areas unprotected by photo-resist without an attack of the silicon surface underlying the mask. Etching processes suffer from at least the following two disadvantages: (1) in the case of dry etching processing, the removal of the masking material without affecting the silicon surface is difficult to obtain (2) in the case of wet etching processing, some degree of etching of the masking material underlying the photo-resist pattern cannot be avoided, thus affecting the desired dimension of the masking-material pattern. Such an over-etching can be highly undesirable, especially during the formation of silicon structures at the nanometer-scale.

An alternative solution that avoids the dry or wet etching step in the patterning of the masking material makes use of the process known as lift-off. In this case, a photo-resist pattern is first defined onto the surface of the silicon wafer, followed by the deposition of the masking material on the full surface of the wafer. Photo-resist removal by the action of a solvent, such as for example acetone, is accompanied by the removal of the masking material in contact with the photo-resist and a pattern corresponding to the location of the masking material directly in contact with silicon surface is obtained. Nevertheless, there are certain important disadvantages of the lift-off process: (1) the deposited masking material is generally a metal, i.e. a substance that when used severely limits the subsequent fabrication steps allowable in standard silicon integrated circuit technology, and/or is vulnerable to acid cleaning frequently applied for the removal of stubborn photo-resist residues onto the silicon surfaces, (2) severe limitations exist regarding the details of the photo-resist profile, and, specifically, the features of the defined pattern should have negatively sloped side-walls, for lift-off to be successful.

Moreover, the aforementioned standard procedures of forming and patterning masking material onto the surface of a silicon wafer present a major disadvantage if they are intended for the micromachining of silicon structures with vertical sidewalls (i.e. normal to the surface of the silicon wafer), hereafter referred as mesas, made in (100)-oriented silicon wafer. In this case, standard masking materials such as SiO₂, Si₃N₄, or metal films are developed on all available surfaces thus preventing wet etching of the mesa vertical sidewalls. Consequently, for processes aiming at a wet etching of the mesa sidewalls (see, for example, J. L. Liu et al. (1996), "Study of dry oxidation of triangle-shaped silicon nanostructure", Appl. Phys. Lett. 69, 1761-1763, and European Patent Application, Appl. No 89115097.1, Publ. No 0413040, filed Aug. 16, 1989, T. Bayer et al., inventors), just the top surface of the mesas can be protected against anisotropic etchant solutions, thus resulting in an undesirable etching of silicon surrounding the mesas.

DE 198 44 418 discloses the principle of exposing a surface of a silicon wafer to a fluorocarbon-based plasma so as to form a masking composite material thereon. DE 19844418 specifies that the masking material should have a thickness from 100 to 2000nm in order to provide sufficient protection against aggressive hot alkaline etching solutions including KOH, NaOH and TMAH. This thickness requirement imposes severe materials and processing limitations. For example, in the case where such a protective layer is formed onto a silicon surface by a lift-off process, thick removable patterned materials such as photo-resist should be required for lift-off to be successful. In addition, micromachining of vertical or recessed sidewalls of monocrystalline silicon structures formed in a silicon wafer should be limited to silicon structures with vertical dimensions at least higher than 100nm, and in this case to those portions of the sidewalls of the silicon structures above 100nm from the silicon wafer surface.

US 4,371,407 discloses the principle of exposing a surface of material films formed on a semiconductor substrate, to a fluorocarbon-based plasma so as to create a protective layer of composite material about 80nm thick thereon. US 4,371,407 is not concerned with the use of said protective layer on a silicon surface for the purpose of forming micromachined silicon structures using anisotropic etchant solutions.

Both DE 198 44 418 and US 4,371,407 specify that the protective layer should have a thickness of at least 80 nm in order to provide sufficient protection when subsequently using aggressive etching techniques such as reactive ion etching or hot alkaline solutions.

A protective layer having such a thickness is completely unsuitable for micromachining applications where a far greater resolution is required.

In general, micromachining technology is continuously seeking ways to overcome the aforementioned limitations of the standard procedures for selectively masking silicon surfaces against anisotropic wet etchants. A method whereby these limitations could be eliminated is therefore desirable for the production of silicon structures in a highly controllable and reproducible manner.

It is a general aim of the invention to provide a method for the micromachining of silicon wafer which negates the processing limitations imposed by the aforementioned techniques.

According to the invention there is provided a method, according to claim 1.

Preferably the method of the invention includes further features as defined in dependent claims 2 to 6.

It is an advantage of the invention to provide a method for masking mono-crystalline or poly-crystalline silicon surfaces against a wide variety of anisotropic wet etchants for the purpose of forming micromachined or nanomachined silicon structures.

It is another advantage of the invention that the method entails the use of a masking material that does not require a dry or wet etching step for its patterning.

It is yet another advantage of the invention that the method is fully compatible with standard silicon integrated circuit technology.

It is a further advantage of the invention that the method allows micromachining of vertical sidewalls or recessed sidewalls of monocrystalline silicon structures formed in a silicon wafer, without affecting any other silicon surfaces.

In accordance with preferred embodiments of the invention, the above, as well as other advantages are accomplished as follows.

According to the invention, a method is provided for the masking of one or more surfaces of a mono-crystalline silicon wafer against anisotropic wet etchants during the formation of micromachined and nanomachined silicon structures. The method of the invention can also be applied to one or more surfaces of a poly-crystalline silicon layer deposited on a processed silicon wafer, or to surfaces of vertical mono-crystalline silicon structures made in a silicon wafer. The method of the invention involves the formation of a masking material on the aforementioned silicon surfaces to protect them during silicon wet etching in anisotropic etchant solutions.

The masking material is formed following the exposition of the above said surfaces to fluorocarbon-based plasmas. It is known in semiconductor industry that plasma-assisted processing utilizing active species of the CₓF_{y} or CₓF_{y}H_{z} type, where x,y and z are small positive integral numbers or equal to zero, allows for the generation of a composite material, hereafter referred as CMP (Composite Material by Plasma) onto a silicon surface that includes a fluorocarbon top film and an underlying thin silicon sub-oxide film. Examples of gases appropriate for the aforesaid plasma processing include CHF₃, CF₄, C₄F₈, C₂F₄, C₂F₆, C₃F₆, C₆F₆, CF₄/H₂, C₄F₈/H₂ and mixtures of them, as reported widely in literature, as for example in J.A. Theil (1999), "Fluorinated amorphous carbon films for low permittivity interlevel dielectrics", J. Vac. Sci. Technol. B 17(6), 2397-2410. The chemical composition, thickness and other properties of a CMP film as a function of the plasma processing parameters, such as the composition and flow rate of the fluorocarbon gas used, the pressure and duration of the plasma, and the subsequent to plasma processing exposure of the silicon surfaces to air, have been widely reported in the literature and are described, for example, in G. S. Oehrlein (1989), "Dry etching damage of silicon: A review", Materials Science and Engineering B4, 441-450.

According to the invention, a CMP film, when formed under appropriate plasma conditions, offers a unique protection of silicon against EPW solutions and remains resistant to such solutions at elevated temperatures typically applied for residue-free etching of bulk silicon. In addition, it is disclosed that once CMP is properly annealed, the newly developed film material, hereafter referred as ACMP, is highly resistant to at least three anisotropic wet etchants, namely: EPW, KOH, and TMAH.

The CMP films are known in semiconductor device technology and are often applied for the purpose of SiO₂/Si (or Si₃N₄/Si) selectivity during reactive ion etching or inductively coupled plasma etching, but such films, or their annealed versions (i.e. ACMP films), were never developed or intended as silicon-masking materials against anisotropic wet etchants, and such use was neither known nor expected by those who invented or subsequently used these films.

According to this invention, a protective film formed of CMP is used during the fabrication of micromachined silicon structures. An example of structures processable in accordance with this invention are V-shaped grooves formed into a silicon wafer for the purpose of a wide range of applications including but not limited to alignment of optical wave-guides (see, for example, UK Patent Application, Appl. No 8614286, filed Jun. 12, 1986, Publ. No GB-2 191 601, N. J. Parsons, inventor) and fabrication of silicon lenses (see, for example, United States Patent, Appl. No 489,222, filed Apr. 27, 1983, Patent No 4,524,127, J. Kanes, inventor). Another example of structures than can be micromachined in accordance with this invention are mesa structures with vertical sidewalls terminated by two symmetrical shapes with a trapeze-shaped cross-section. Such mesa structures in the form of silicon pillars with precisely tailored ends of pointed shape are appropriate for a variety of applications including but not limited to tips for profiling of three-dimensional structures by atomic force microscope (AFM) and scanning tunneling microscope (STM) micro-profilometry such as described in the aforementioned European Patent A-0413040 to Bayer et al.

The method of this invention entails exposing one or more silicon surfaces of a silicon wafer to fluorocarbon plasma in order to form a CMP film onto the said exposed surfaces that are to be protected during micromachining of silicon structures. Subsequently, anisotropic wet etching of CMP non-protected silicon surfaces is done in EPW solutions for the fabrication of the desired silicon structures. Alternatively, the CMP film can be thermally annealed in order to form a new protective film (ACMP) that prevents etching in solutions such as KOH or TMAH of the silicon surfaces underlying the protective film. Following, the etching step, removal of the CMP or ACMP film can be accomplished by using a dry or wet etching technique or a combination of both techniques.

According to this invention, exposition of mesa structures with vertical sidewalls or recessed sidewalls, generated on a silicon wafer, to fluorocarbon plasma under appropriate conditions, leads to the formation of an etchant-resistant CMP film only onto the silicon surfaces exposed to the plasma energetic-ion flux. The direction of the ion flux is mainly perpendicular to the wafer surface. Such a selective formation of the CMP film allows micromachining by anisotropic wet etching of the vertical sidewalls or recessed sidewalls of the mesas without affecting any other silicon surface. A method for the selective masking of silicon surfaces without the need of photolithographic process was not known and consequently, this invention offers a processing option capable of overcoming the limitations of prior art masking processes.

The above, as well as other advantages of this invention will become more apparent through the following description with respect to the accompanying drawings in which:
Figs. 1A through 1F illustrate a series of steps used to fabricate a V-shaped groove into a silicon wafer according to a method which does not be long to the invention and is described for illustrative purposes only.
Figs. 2A through 2D illustrate a series of steps used to micromachine the vertical sidewalls of a mesa structure, such as a silicon pillar, developed on a silicon wafer without affecting any other exposed silicon surface in accordance with the invention.

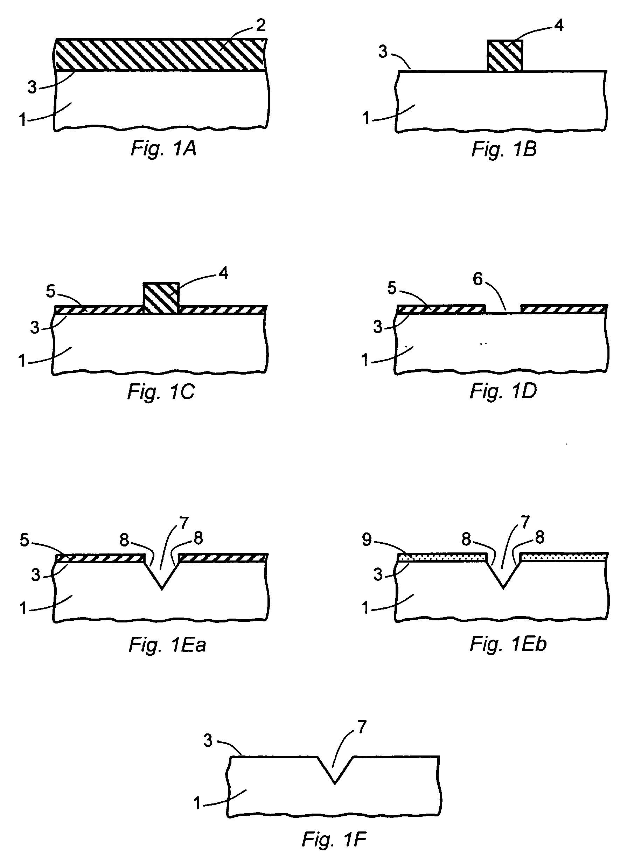

Fig. 1A shows the initial structure for the fabrication of a V-shaped groove into an (100)-oriented silicon wafer (1). The top surface (3) of the wafer (1) is coated with a conventional positive or negative tone photo-resist layer (2), such as AZ 5214 of the Clariant company. The photoresist-coated-wafer is then exposed to light through a photo-mask bearing a rectangular or square pattern. The dimensions of the pattern determine the dimensions of the aperture of the V-groove as it will be apparent in the next fabrication steps. It is of course understood that although the fabrication of only one V-groove is illustrated, the invention is not to be restricted thereby and a array of the said above patterns may be employed leading for example to the formation of V-groove arrays. Further, the sides of the said rectangle or square of the photo-mask pattern must be parallel to the <110> crystallographic direction of the silicon wafer that corresponds to the wafer flat. Such an alignment is critical for the control of the symmetry, size and relative alignment of the V-groove. Following exposure, the photo-resist layer (2) is developed in accordance with standard photolithographic techniques, thus reproducing the photo-mask pattern in the photo-resist layer. The patterned photo-resist layer (4) onto the surface (3) of the silicon wafer (1) is shown in Fig. 1B.

The next fabrication step consists of the formation of a composite material, said CMP film, onto those silicon surface areas of the wafer (1) not protected by photo-resist. A CMP film is formed following the exposition of the said above surfaces to fluorocarbon-based plasmas formed, for example, in reactive ion etching (RIE) or inductively coupled plasma (ICP) commercially available machines, such as Nextral 330 and Alcatel MET, respectively. Employing any of these machines, it has been found that after air exposure, a CMP film made of a fluorocarbon film and an underlying silicon sub-oxide film generated on silicon is highly resistant to EPW etching solutions when proper plasma processing is performed. A preferred plasma process used in the RIE equipment incorporates a CHF₃ fluorocarbon gas with a flow rate of 50 standard cubic centimeters per minute, a radio-frequency power density and a total pressure of about 0.5 watt per square centimetre and 0.01 Torr respectively, as well as a plasma duration of about 40 seconds. This simple and rapid, roomtemperature dry processing leads to the formation of the CMP film (5) with a thickness of the order of 5 nanometers onto the silicon area defined by photo-resist patterning, as shown in Fig. 1C.

After formation of said CMP film (5), the wafer is dipped in ultrasonically agitated acetone for about 15 min for the purpose of resist removal. Such an acetone stripping treatment does not affect significantly said CMP film (5). The wafer at this stage in the process is shown in Fig. 1D.

The next fabrication step consists of the exposure of the silicon wafer to an EPW solution that etches silicon anisotropically in the silicon area (6) non-covered by said CMP film (5), and leads to the formation of a V-groove structure (7) into the silicon wafer (1) as shown in Fig. 1Ea. Since the sides of the rectangle or square of the photo-mask pattern have been aligned with the <110>-oriented flat of the silicon wafer, the walls of the V-groove (7) are defined by four {111} crystal planes, that appear as two {111} planes (8) in cross-sectional view as illustrated by Fig. 1Ea. A preferred EPW composition useable in the example of this invention is 400 milliliters of ethylenediamine, 63.0 grams of pyrocatechol, and 128 milliliters of water, at a temperature of 110°C. Such a composition etches (100)-oriented silicon at a rate of the order of 40 micrometers per hour and does not affect significantly the CMP film (5) for etching times as long as 40 minutes. Such etching times allow for the formation of V-grooves with a depth as large as approximately 30 micrometers corresponding to a width, at the level of the wafer surface, of about 42 micrometers.

Although the formation of a CMP film under specific plasma conditions is illustrated, other fluorocarbon-based plasma conditions can be employed. More particularly, it has been found that CHF₃-based RIE exposure times ranging from about 20 to about 120 seconds lead, following the use of the above preferred EPW solution, to V-groove etch depths ranging from about 20 to about 60 micrometers respectively.

Importantly, the thin native oxide that forms on CMP non-covered silicon surfaces upon exposure to air, interferes with the etching process and has to be removed prior to immersion of the silicon wafer into the EPW solution. Native oxide removal is commonly performed in fluoride-aqueous environments, such as hydrofluoric acid (HF) solutions or buffered HF (BHF) solutions. The etching of the native oxide is preferably done using either a solution of 2 parts by volume of HF in 98 parts of water for duration of about 40 seconds, or a BHF solution, such as ammonium fluoride etchant AF 87.5-12.5 from the Merck company, for about 15 seconds. It has been found that these isotropic acid treatments do not attack the CMP film (5) or affect the resistance of said CMP film (5) to EPW solution.

A CMP film can be thermally annealed at temperatures in the range of 600 to 1000°C in order to form a new protective film (previously referred as ACMP film) that prevents etching of silicon in EPW and other solutions, such as KOH or TMAH. A preferred process useable in the present example is as follows. After the step of resist removal, the silicon wafer (1) with the patterned CMP film (5) thereon as illustrated in Fig. 1D, is annealed at a temperature of about 950°C for a duration of about 30 minutes in a nitrogen atmosphere. Such a treatment leads to the formation of an ACMP film (9) onto the previously CMP-capped silicon surfaces. After annealing the wafer is immersed in a KOH solution made of 20 parts by weight of KOH in 80 parts of water, at a temperature of about 60°C. Anisotropic silicon etching occurs in the silicon area non-protected by the ACMP film (9), and leads to the formation of a V-groove structure into the silicon wafer, as shown by Fig. 1Eb. Depth of V-grooves attainable by this process is as large as approximately 25 micrometers, with a corresponding groove width, at the level of the wafer surface, as large as approximately 35 micrometers.

Importantly, it has been found that a pre-annealing wet chemical cleaning of the wafer through the use of standard acid treatments, such as for example a mixture of sulfuric acid and nitric acid in volume proportions 9:1 at temperatures in the range of 80°C to 140°C for about 15 minutes, does not affect the etchant-resistance of a ACMP film. In addition, it has been found that treatments in fluoride-aqueous environments used for example for the purpose of native oxide removal as described above, do not attack a ACMP film or affect its resistance to anisotropic etchant solutions.

Fig. 1F illustrates the result of removing the CMP film (5) or the ACMP film (9). The films (5) and (9) can be removed by dry or wet etching or a combination of both procedures. CMP cleaning including dry and wet etching steps is well-known in the semiconductor industry and is described, for example, by Aoto et al. (1995), "Native oxides on Si surfaces of deep-submicron contact-hole bottoms", J. Appl. Phys. 77, 3899-3907. A similar cleaning procedure can be also applied to remove a ACMP film. According to the present invention, a suitable wet etching process for removing said CMP film (5) is preferably the use of a mixture of sulfuric acid and nitric acid in volume proportions 9:1 at a temperature on the order of 150°C for about 20 minutes, followed by a treatment in a mixture of hydrofluoric acid and water in volume proportions 1:4 at room temperature for a duration of about 2 minutes.

Although the method has been illustrated above with reference to V-groove structures, this method is equally applicable to the fabrication of three-dimensional structures of different geometries, such as V-grooves with L-shaped apertures or truncated V-grooves, which can be controlled in numerous ways, as for example by the photo-resist patterning preceding the formation of a CMP film or the etching time in anisotropic etchant solutions.

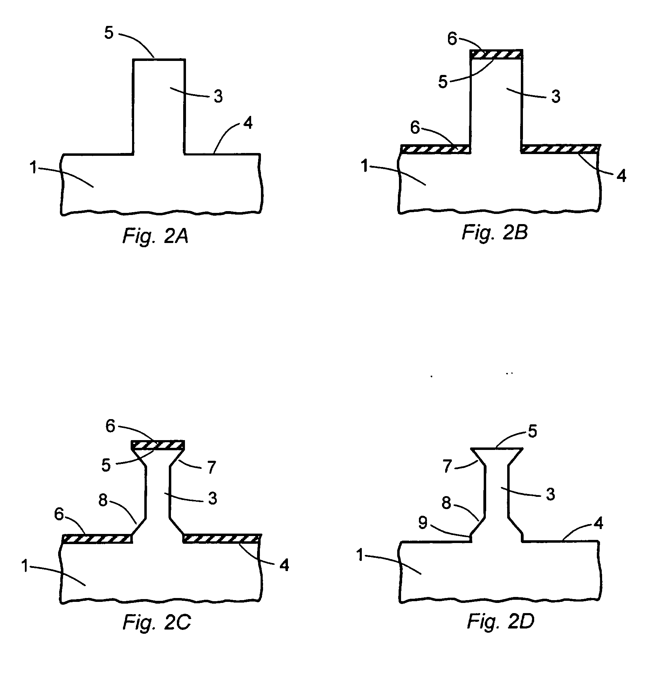

An example of the method of the invention is described in accordance with Fig. 2A-D. This example relates to the micromachining of the vertical sidewalls of a mesa structure developed on a silicon wafer, without affecting any other silicon surface.

Fig. 2A illustrates an (100)-oriented silicon wafer (1) in which a mesa structure (3) with vertical sidewalls normal to the surface (4) of the wafer (1) has been formed. Though the mesa structure (3) is illustrated as a single pillar with a rectangular vertical cross-section, the invention is not to be restricted thereby and an array of pillars and a plurality of mesas with different geometries, such as vertical trenches or pillars with recessed sidewall profiles (i.e. the pillar top width is larger than the width along the pillar height) can be employed. Fabrication of vertical structures on a silicon wafer is well known in the semiconductor industry and is described, for example, in the aforementioned European Patent A-0413040 to Bayer et al., and in J. K. Bhardwaj and H. Ashraf (1995), "Advanced silicon etching using high density plasmas", SPIE Proceedings Vol. 2639, 224-233.

A preferred process for fabricating said mesa structure (3) is as follows. Said silicon wafer (1) is coated with a photo-resist layer (not shown) of about 2 micrometers thick. The photoresist is then exposed to light through a photo-mask bearing the pattern of the future silicon pillar, and subsequently developed. The photo-resist pattern is then transferred deep into the silicon wafer by reactive ion etching (RIE) using a mixture of 25 sccm SF₆ and 25 sccm CHF₃ gases, a radio-frequency power density and a total pressure of about 0.5 watt per square centimetre and 0.01 Torr respectively, with the wafer on a powered electrode covered by a graphite sheet, for a time depending on the desired etch depth. The remaining photo-resist on the top surface of the pillar is then stripped away and wet chemical etching of the wafer is done to remove polymer residues deposited onto the sidewalls of the pillar during the RIE process. This wet cleaning step is preferentially performed in a mixture of sulfuric acid and hydrogen peroxide in volume proportions 2:1 at a temperature of about 130°C for a duration of 15 minutes. The wafer at this stage in the process is shown in Fig. 2A. The silicon pillar (3) of this example has a height as large as 2 micrometers and a width of about 1 micrometer.

According to the invention, the next fabrication step consists of the formation of an CMP film both on the top surface (5) of said pillar (3) and the surrounding silicon surfaces (4). Importantly, the CMP film is generated only onto the silicon surfaces exposed to the plasma ion flux that is perpendicular to the wafer surface and consequently no CMP film is formed onto the vertical sidewalls of the pillar, thus allowing further etching of said sidewalls in EPW solution. The CMP film (6) shown in Fig. 2B is preferably obtained using a RIE equipment incorporating a CHF₃ fluorocarbon gas with a flow rate of 50 standard cubic centimeters per minute, a radio-frequency power density and a total pressure of about 0.5 watt per square centimetre and 0.01 Torr respectively, as well as a plasma duration of about 40 seconds.

The next fabrication step consists of the exposure of the silicon wafer to an EPW solution that anisotropically etches the CMP non-protected sidewalls of the pillar. This etching process leads to the formation of a pillar with reduced cross-sectional area and triangle-shaped recessed profiles (7) and (8) at its extremities as illustrated by Fig. 2C. The recessed profiles (7) and (8) appear as two {111} planes in cross-sectional view of Fig. 2C. A preferred EPW composition useable in this second example of the invention is 400 milliliters of ethylene-diamine, 60.0 grams of pyrocatechol, and 54 milliliters of water, at a temperature of about 40°C and a time depending on the desired dimensions of the final pillar. Such a composition etches (100) and (110) oriented silicon at a rate of the order of 1.5 micrometer per hour and does not affect significantly the CMP protective film (6) for etching times as long as 2 hours. The final pillar shape (see Fig. 2D) is obtained after removal of said CMP film (6) by dry or/and wet etching as previously described. The height of the step-like structure (9) at the bottom of the pillar corresponds to the thickness of the CMP film (6) and is on the order of 5 nanometers for the preferred CHF₃ plasma conditions used for the formation of said CMP film (6). According to the invention, pillars with an aspect ratio (i.e. a height -to-width ratio) of the order of 10 or much larger and precisely tailored ends of pointed shape obtained by anisotropic wet etching of the pillar-sidewalls only, have been fabricated and can be used as tips for profiling three-dimensional structures in AFM/STM profilometry as described for example in the aforementioned European Patent A-0413040. With the method of the invention, nano-pillars (say to a final width as low as 10 nanometers) with an aspect ratio of 40 and bound by two symmetric triangle-shaped structures have been also fabricated.

According to the method of the invention, anisotropic wet etching limited to the vertical sidewalls of pillars or other vertical-wall structures, including trenches, formed in a bulk silicon wafer without the use of any lithographic procedure and without affecting any other silicon surfaces was not known or expected.

Although the invention has been illustrated in detail with reference to V-groove and pillar structures in a monocrystalline silicon wafer, CMP film or its annealed version (said ACMP film) can be also used to protect one or more surfaces made of polycrystalline silicon against anisotropic etchant solutions.

## Claims

1. A method for micromachining an already three-dimensionally structured silicon body comprising the following steps:
(a) providing a silicon body having a silicon structure with vertical sidewalls or recessed sidewalls;
(b) exposing said silicon body with said silicon structure to a fluorocarbon-based plasma to form a composite material made of a fluorocarbon film and an underlying silicon sub-oxide film onto the silicon surface portions other than the vertical sidewalls or recessed sidewalls of said silicon structure; and
(c) etching said silicon body with said silicon structure in an anisotropic etchant solution so as to micromachine said vertical sidewalls or recessed sidewalls of said silicon structure.

2. The method of claim 1, wherein the fluorocarbon-based plasma uses volatile individual substances or mixtures thereof which, under plasma conditions, yield active species of the CₓF_{y} type or CₓF_{y}H_{z} type, where x, y and z are positive integral numbers.

3. The method of claim 1, wherein said fluorocarbon-based plasma uses gases selected from CHF₃, CF₄, C₄F₈, C₂F₄, C₂F₆, C₃F₆, C₆F₆, CF₄/H₂, C₄F₈/H₂ and mixtures thereof.

4. The method of claim 1, wherein the composite material is formed in a reactive ion etching machine with CHF₃ as a fluorocarbon gas, a pressure of about 0.01 Torr, a power density of about 0.5 watt per square centimetre, as well as a duration of about 20 seconds to about 120 seconds.

5. A method according to any preceding claim, wherein the anisotropic etchant solution uses a composition of ethylenediamine, pyrocatechol, and water.

6. A method according to claims 1-4 further including the step before step (c) of annealing the composite material at a temperature of about 600°C to 1000°C to form a masking material that prevents silicon etching in solutions selected from aqueous potassium hydroxide (KOH) solution and aqueous tetramethylammonium hydroxide (TMAH) solution.

## Patentansprüche

1. Methode für die Mikro-Materialbearbeitung eines bereits dreidimensional strukturierten Silizium-Körpers, die folgenden Schritte umfassend:
(a) Bereitstellung eines Silizium-Körpers, welcher eine Silizium-Strukur aufweist mit vertikalen Wänden oder Vertiefungen,
(b) Exposition des beschriebenen Silizium-Körpers mit der ebenfalls beschriebenen Struktur gegenüber einem Fluorkohlenstoff-basierenden Plasma, um ein Verbundmaterial aus einem Flurkohlenstoff-Film und einem darunterliegenden Silizium-Sub-Oxid-Film auf den Teilen der Siliziumoberfläche ausser den vertikalen Seitenwänden oder Vertiefungen der genannten Siliziumstruktur zu erzeugen, und
(c) Ätzen des genannten Silizium-Körpers mit genannter Silizium-Struktur in einer anistrop ätzenden Lösung, um eine Materialbearbeitung der vertikalen Seitenwände oder Vertiefungen der beschriebenen Silizium-Struktur durchzuführen.

2. Methode nach Anspruch 1, wo das Flurkohlenstoff-Plasma flüchtige individuelle Substanzen oder Mischungen davon verwendet, welche unter Plasma-Bedingungen aktive Arten von CₓF_{y} Typen or CₓF_{y}H_{z} Typen erzeugen, wobei x und y positive ganze Zahlen sind.

3. Methode nach Anspruch 1, wo das Flurkohlenstoff-Plasma eine Auswahl der folgenden Gase CHF₃, CF₄, C₄F₈, C₂F₄, C₂F₆, C₃F₆, C₆F₆, CF₄/H₂, C₄F₈/H₂ und Mischungen davon verwendet.

4. Methode nach Anspruch 1, wo das Verbundmaterial in einer reaktiven Ionenätzanlage mit CHF₃ als Fluorkohlenstoffgas gebildet wird bei einem Druck von etwa 0,01 Torr, einer Leistungdsichte von etwa 0.5 Watt pro Quadratzentimeter und einer Dauer von etwa 20 Sekunden bis etwas 120 Sekunden.

5. Methode nach einem der vorgenannten Ansprüche, wo die anisotrope Ätzlösung eine Zusammensetzung von Ethylenediamin, Pyrocatechol und Wasser aufweist.

6. Methode nach den Ansprüchen 1-4, umfassend zusätzlich vor Schritt c) eine Ausheilung des Verbundmaterials bei einer Temperatur von etwa 600 °C bis 1000 °C durchgeführt wird, um ein Maskenmaterial zu bilden, das das Silizium vor Ätzen in Lösungen von wässrigen Kaliumhydroxid (KOH)-Lösungen und wässrigen Tetramethylammoniumhydroxid (TMAH)-Lösungen schützt.

## Revendications

1. Une méthode pour micro-usiner un corps de silicium préalablement structuré en trois dimensions comportant les étapes suivantes :
(a) fournir un corps de silicium ayant une structure de silicium avec des parois latérales verticales ou des parois latérales renfoncées;
(b) exposer ledit corps de silicium avec ladite structure de silicium à un plasma à base de fluorocarbone pour former un matériau composite faite d'un film de fluorocarbone et d'un film de sous-oxyde de silicium sous-jacent sur les parties de surface de silicium autres que les parois latérales verticales ou les parois latérales renfoncées de ladite structure de silicium ; et
(c) gravure dudit corps de silicium avec ladite structure de silicium dans une solution gravante anisotrope afin de micro-usiner lesdites parois latérales verticales ou parois renfoncées de ladite structure de silicium.

2. La méthode selon la revendication 1, où le plasma à base de fluorocarbone emploie des substances volatiles ou des mélanges de celles-ci qui, sous des conditions de plasma, génèrent des espèces actives du type CxFy ou du type CxFyHz, où x, y et z sont des nombres entiers positifs.

3. La méthode selon la revendication 1, où ledit plasma à base de fluorocarbone emploie des gaz sélectionnés parmi CHF₃, CF₄, C₄F₈, C₂F₄, C₂F₆, C₃F₆, C₆F₆, CF₄/H₂, C₄F₈/H₂ et leurs mélanges.

4. La méthode selon la revendication 1, où le matériau composite est formé dans une machine de gravure ionique réactive employant CHF₃ comme gaz de fluorocarbone, une pression d'environ 0.01 Torr, une puissance d'environ 0.5 watt par centimètre carré, ainsi qu'une durée allant d'environ 20 secondes à environ 120 secondes.

5. Une méthode selon l'une des revendications précédentes, où la solution gravante anisotrope emploie une composition d'éthylènediamine, de pyrocatéchol et d'eau.

6. Une méthode selon les revendications 1-4 comprenant, avant l'étape (c), l'étape de recuire le matériau composite à une température d'environ 600°C à 1000°C pour former un matériau de masquage qui empêche la gravure de silicium dans des solutions sélectionnées parmi la solution aqueuse d'hydroxyde de potassium (KOH) et la solution aqueuse d'hydroxyde tétraméthylammonium (TMAH)
